(19) Europäisches Patentamt / European Patent Office / Office européen des brevets

(11) **EP 3 733 277 B1**

(12) **EUROPEAN PATENT SPECIFICATION**

(45) Date of publication and mention
of the grant of the patent:
**21.02.2024 Bulletin 2024/08**

(21) Application number: **19172282.6**

(22) Date of filing: **02.05.2019**

(51) International Patent Classification (IPC):
**B01J 19/00** (2006.01)     **B05D 1/38** (2006.01)
**B05D 3/06** (2006.01)      **G03F 7/20** (2006.01)
**B82Y 30/00** (2011.01)     **B05D 5/00** (2006.01)

(52) Cooperative Patent Classification (CPC):
**B01J 19/0046; B05D 1/38; B05D 3/06;
B05D 3/065; B05D 5/00; B05D 5/08; G03F 7/0002;
G03F 7/2014; G03F 7/2022;** B01J 2219/00533;
B01J 2219/00585; B01J 2219/00619;
B01J 2219/00648; B01J 2219/00659;
B01J 2219/00711;                    (Cont.)

(54) **PATTERNED SUBSTRATE HAVING HYDROPHILIC AND HYDROPHOBIC AREAS**

STRUKTURIERTES SUBSTRAT MIT HYDROPHILEN UND HYDROPHOBEN BEREICHEN

SUBSTRAT À MOTIFS PRÉSENTANT DES ZONES HYDROPHILES ET HYDROPHOBES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.11.2020 Bulletin 2020/45**

(73) Proprietor: **Karlsruher Institut für Technologie
(KIT)
76131 Karlsruhe (DE)**

(72) Inventors:
• **LEVKIN, Pavel
76344 Eggenstein-Leopoldshafen (DE)**
• **GRUNZE, Michael
69151 Neckargemünd (DE)**
• **DONG Zheqin
76344 Eggenstein-Leopoldshafen (DE)**
• **DEMIR, Konstantin
76287 Rheinstetten (DE)**
• **WIDMAIER, Simon
67122 Altrip (DE)**
• **BREHM, Marius
76744 Wörth (DE)**
• **POPOVA, Anna
76149 Karlsruhe (DE)**

(74) Representative: **Forstmeyer, Dietmar et al
Boeters & Lieck
Oberanger 32
80331 München (DE)**

(56) References cited:
**EP-A1- 3 205 394     US-A1- 2011 059 264**

• **RYAN M. HENSARLING ET AL:
""Clicking" Polymer Brushes with Thiol-yne
Chemistry: Indoors and Out", JOURNAL OF THE
AMERICAN CHEMICAL SOCIETY, vol. 131, no. 41,
21 October 2009 (2009-10-21), pages
14673-14675, XP055014199, ISSN: 0002-7863,
DOI: 10.1021/ja9071157**
• **PHILIPPE TINGAUT ET AL: "Highly efficient and
straightforward functionalization of cellulose
films with thiol-ene click chemistry", JOURNAL
OF MATERIALS CHEMISTRY, vol. 21, no. 40, 1
January 2011 (2011-01-01), page 16066,
XP055238754, GB ISSN: 0959-9428, DOI:
10.1039/c1jm11620g**
• **WENQIAN FENG ET AL: "Surface Patterning via
Thiol-Yne Click Chemistry: An Extremely Fast
and Versatile Approach to
Superhydrophilic-Superhydrophobic
Micropatterns", ADVANCED MATERIALS
INTERFACES, vol. 1, no. 7, 1 October 2014
(2014-10-01) , pages 1400269-n/a, XP055285895,
DE ISSN: 2196-7350, DOI:
10.1002/admi.201400269**

(52) Cooperative Patent Classification (CPC): (Cont.)
B05D 1/02; B05D 3/0263; B05D 3/029;
B05D 2203/35; B82Y 30/00

## Description

The present invention relates to a patterned substrate having hydrophilic and hydrophobic areas and to methods for producing said patterned substrate.

High-throughput screening (HTS) approaches play a crucial role in identifying effective treatments for literally all diseases. High-throughput screening campaigns are used to perform and evaluate hundreds of thousands of biological experiments in parallel every day, yet current methods have significant limitations.

Most cell-based screening experiments are currently performed on microplates (or microtiter plates), which are relatively inefficient. Large pharmaceutical companies typically screen over 100,000 compounds a day, so a lot of microplates and large reagent volumes are required. Cell compatibility and cost are also major concerns to pharmaceutical companies and academic laboratories, where many cell-based screenings are performed. Currently, consumables account for around 75 percent of the cost of HTS to pharmaceutical companies. By downscaling screening experiments, it is possible to invest the consumables more efficiently.

Superhydrophilic micro-arrays, which have a strong affinity to water, separated by superhydrophobic, water-repellent barriers can be used to create high-density arrays of microdroplets. Due to the high difference in the wettability of these two areas, the application of an aqueous solution on top of the surface leads to the spontaneous formation of microdroplets. Each of these droplets in the so-called Droplet Microarray (DMA) can then serve as a micro-reservoir for carrying out reactions or for culturing cells. With the DMA technology, at least 95 percent of reagents can be saved, compared to even the best microtiter plates available in the market.

Discontinuous dewetting is a powerful method enabling the generation of thousands of microdroplets with a specific geometry, volume and at predefined locations on a patterned substrate. During the discontinuous dewetting process, liquid is moved along a surface possessing strong dewettability with a pattern of highly wettable spots to create an array of pinned droplets from picoliter up to microliter volumes. The advantages of this procedure are that it is a single-step method, permits massive parallelization, is compatible with high-throughput screening (HTS) experiments but does not depend on expensive robotics and automation, thereby minimizing experimental costs. These advantages make this method attractive for HTS of cells including single cell screenings, diagnostic or personalized medicine applications.

Recently several biological applications requiring both miniaturization and multiplexing have been realized via discontinuous dewetting. Superhydrophobic-superhydrophilic microarrays were used to create droplet-microarrays for high-throughput screening of living cells, to create arrays of hydrogel micropads and for single cell screening. Driven by surface tension, cell-laden hydrogels were assembled on a glass surface patterned with hydrophobic and hydrophilic regions.

A patterned substrate including a surface having a patterned coating comprising hydrophilic areas including hydrophilic thioether groups surrounded by hydrophobic areas including hydrophobic thioether groups separating the hydrophilic areas into a predetermined spatial pattern is described in EP 3 205 394. Due to the specific structure of the patterned substrate described therein, it is possible to adjust the properties of the hydrophilic and hydrophobic areas (e.g. the desired contact angle for a certain liquid) by appropriately selecting the hydrophilic and hydrophobic thioether groups.

Further prior art is disclosed in Ryan M. Hensarling et al., ""Clicking" Polymer Brushes with Thiol-yne Chemistry: Indoors and Out", J. Am. Chem. Soc. 2009, vol. 131, no. 41, 14673 - 14675 (doi:10.1021/ja9071157); Philippe Tingaut et al., "Highly efficient and straightforward functionalization of cellulose films with thiol-ene click chemistry", J. Mater. Chem., 2011, vol. 21, no. 40, 16066 - 16076 (doi:10.1039/c1jm11620g); US 2011/0059264 A1; and Wenqian Feng et al., "Surface Patterning via Thiol-Yne Click Chemistry: An Extremely Fast and Versatile Approach to Superhydrophilic-Superhydrophobic Micropatterns", Adv. Mater. Interfaces 2014, vol. 1, no. 7, 1400269 (doi:10.1002/admi.201400269).

However, the patterned substrate and the processes for producing this patterned substrate described in EP 3 205 394 have several shortcomings, e.g. that the patterned substrates disclosed in EP 3 205 394 are not applicable for producing aqueous droplet arrays, which limits their usage in most biological applications.

Accordingly, it was the object of the present invention to overcome these shortcomings.

The present invention relates to a patterned substrate including a surface having a patterned coating, the patterned coating comprising:

> (i) hydrophilic areas including nanoparticles carrying hydrophilic groups; surrounded by
> (ii) hydrophobic areas including nanoparticles carrying hydrophobic thioether groups.

The nanoparticles that are used in the present invention are silica nanoparticles, alumina nanoparticles, titania nanoparticles or zinc oxide nanoparticles.

Preferably, the hydrophilic groups are hydrophilic thioether groups or oxidized organic groups.

This patterned substrate of the present invention is preferably produced by one of the methods of the present invention. Accordingly, the preferred features disclosed with respect to the methods of the present invention preferably also apply (or lead to) to preferred features of the patterned substrate of the present invention.

The present invention further relates to a method of producing a patterned substrate having hydrophilic areas that are surrounded by hydrophobic areas, comprising the following steps:

    (a) providing a composition (A) containing nanoparticles and a trialkoxy or dialkoxyalkyl silane containing a double bond or a triple bond in a solvent;
    (b) providing a substrate having a surface (B);
    (c) applying the composition (A) onto the surface (B) of the substrate;
    (d) drying the substrate carrying the composition (A);
    (e) contacting surface (B) with a hydrophobic or a hydrophilic thiol or a hydrophobic or a hydrophilic disulfide (especially a hydrophobic or a hydrophilic thiol);
    (f) irradiating part of surface (B) with UV light;
    (g) contacting surface (B) with a hydrophilic or a hydrophobic thiol or a hydrophilic or a hydrophobic disulfide (especially a hydrophilic or a hydrophobic thiol); and
    (h) irradiating surface (B) with UV light.

In one of steps (e) and (g), surface (B) is contacted with a hydrophobic thiol or disulfide and in the other one of steps (e) and (g), surface (B) is contacted with a hydrophilic thiol or disulfide.

Step (f) can be performed either in the liquid phase or in a solid-state phase after evaporation of the solvent used to dissolve the thiol (and/or the photoinitiator).

In a preferred embodiment, step (f) is performed in the solid-state phase.

In a further preferred embodiment, step (h) is performed in the solid-state phase.

The absence of a solvent during the UV-irradiation step avoids the problem of generation of bubbles and of formation of defects which may occur during a liquid UV-irradiation process, it further solves the problem of solvent evaporation making the process easier and faster and more reliable.

Avoiding liquids in the whole process makes the overall procedure more compatible with automation which is critical for scaling up the production.

According to a preferred embodiment, steps (a) to (h) are carried out in the order indicated above.

The term "surface (B)" relates to surface (B) provided in step (b) as well as surface (B) resulting from the subsequent steps (e.g. step (d)).

Preferably, in step (e) surface (B) is contacted with a hydrophobic thiol or disulfide (especially thiol) and in step (g) surface (B) is contacted with a hydrophilic thiol or disulfide (especially thiol).

Preferred nanoparticles that may be used in the present invention are silica nanoparticles.

The nanoparticles may have substantially equal diameters, or alternatively have a spectrum of diameters. Preferably, at least some of the particles have diameters within a range from 1 nm to 10 $\mu$m. More preferably, the range is from 1 nm to 1 $\mu$m. Still more preferably, the range is from 1 nm to 300 nm. Even more preferably the range is from 10 nm to 50 nm with hydrodynamic diameter measured by dynamic light scattering preferably between 50 and 300 nm.

According to one preferred embodiment, fumed silica is used as nanoparticles in composition (A) and in features (i) and (ii) of the patterned substrate. Such fumed silica is e.g. sold under the trademark Aerosil®.

Examples of the trialkoxy or dialkoxyalkyl silane containing a double bond or a triple bond used in composition (A) are trialkoxyvinylsilanes such as vinyltrimethoxysilane, vinyltriethoxysilane, vinyltripropoxysilane, vinyltributoxysilane, allyltrimethoxysilane, allyltriethoxysilane, butenyltrimethoxysilane, butenyltriethoxysilane, ethynyltrimethoxysilane and ethynyltriethoxysilane; dialkoxyalkylvinylsilanes such as methylvinyldimethoxysilane, methylvinyldiethoxyvinylsilane, methylvinyldipropoxysilane, methylvinyldibutoxysilane, methylallyldimethoxysilane, methylallyldiethoxysilane, methylethynyldimethoxysilane, and methylethynyldiethoxysilane. An especially preferred example of the trialkoxy or dialkoxyalkyl silane containing a double bond or a triple bond is trimethoxyvinylsilane.

The solvent used in composition (A) is not particularly limited. Examples of the solvent used in composition (A) are alcohols such as e.g. methanol, ethanol, n-propanol, isopropanol, n-butanol and isobutanol; ketones such as acetone, methyl ethyl ketone, methyl isopropyl ketone, methyl isobutyl ketone and cyclohexanone; esters such as methyl acetate, ethyl acetate, n-propyl acetate, isopropyl acetate, butyl acetate and isobutyl acetate; ethers such as diethyl ether, methyl propyl ether, methyl isopropyl ether, methyl butyl ether and methyl tert-butyl ether; and hydrocarbons such as hexane, cyclohexane, heptane, isooctane, toluene, xylene and mineral spirit.

The material of the substrate is not particularly limited. Examples of the substrate material include glass, plastic, ITO (indium-tin-oxide), silicon, quartz, COC (cyclic olefin copolymer), PS (polystyrene), PMMA (poly(methyl methacrylate)), paper, cellulose and metallic materials. Preferably, surface (B) of the substrate is flat. The substrate may e.g. be in the form of a slide, a wafer, a plate, a film or a sheet. Especially preferably, the substrate is a glass slide. The patterned substrate of the present invention preferably comprises such a substrate.

In step (c) the composition (A) is preferably applied onto surface (B) by spin coating, dip coating or spray coating; especially by spin or spray coating, preferably by spray coating. Spray coating is advantageous, because it makes the process significantly faster.

In step (d) the drying may e.g. be carried out by heating the substrate to a temperature of e.g. 100°C or above such as e.g. to 130°C or above. Further, drying may be carried out by irradiation with microwave or by IR.

Preferably, after drying step (d), the coating layer has a thickness from 10 nm to 50 $\mu$m, more preferably from 50 nm to 10 $\mu$m, most preferably from 100 nm to 2 $\mu$m.

Further preferably, the patterned coating of the patterned substrate of the present invention has a thickness from 10 nm to 50 µm, more preferably from 50 nm to 10 µm, most preferably from 100 nm to 2 µm.

In a preferred embodiment, the hydrophobic thiol is an (preferably unfunctionalized) alkyl thiol or a polyfluoroalkyl thiol (i.e. a compound of formula R'-SH, wherein R' is an (preferably unfunctionalized) alkyl group or a polyfluoroalkyl group (e.g. a perfluoroalkyl group). Preferably, the alkyl group is a linear, branched, or cyclic $C_6$-$C_{30}$ alkyl group. It is further preferred that the polyfluoroalkyl group is a branched or linear $C_1$ to $C_{14}$ polyfluoroalkyl group, more preferred is a linear $C_4$ to $C_{12}$ polyfluoroalkyl group (preferably containing from 5 to 25 fluorine atoms). Particularly preferred is 1H,1H,2H,2H-perfluorodecanethiol ($F_3C(CF_2)_7(CH_2)_2SH$) (PFDT).

In a further preferred embodiment, the hydrophilic thiol is a functionalized alkyl thiol (i.e. a compound of formula R-SH, wherein R is a functionalized alkyl group). "Functionalized" means that the alkyl group may have one or more functional groups, which preferably are selected from the group consisting of amine ($NH_2$), hydroxyl (OH), carboxyl ($CO_2H$) and sulfonyl hydroxide (SOsH). It is preferred that the functionalized alkyl has one functional group. Preferably, the alkyl group is a linear or branched $C_1$ to Ca alkyl group, more preferably a linear $C_2$ or $C_3$ alkyl group. Preferably, the functional group of the linear alkyl group is at the terminal position. Particularly preferred hydrophilic thiols are selected from 2-aminoethanethiol (cysteamine) and 2-mercaptoethanol. Further preferred hydrophilic thiols include the amino acid cysteine, cysteine-containing hydrophilic proteins, cysteine-containing hydrophilic peptides, thiol-containing sugars, thiol-PEG, or thiol-bearing PVA polymer, and thiol-polysaccharides. In another preferred embodiment, the hydrophilic thiol is a thiol functionalized biomolecule, such as biotin-PEG-SH, wherein "PEG" means polyethylene glycol and "SH" indicates the thiol residue.

Herein, the term "alkyl" refers to a saturated, straight-chain or branched hydrocarbon group that contains from 1 to 20 carbon atoms, preferably from 1 to 12 carbon atoms, especially from 1 to 6 (e.g. 1, 2, 3 or 4) carbon atoms, for example a methyl, ethyl, propyl, isopropyl, n-butyl, iso-butyl, sec-butyl, tert-butyl, n-pentyl, iso-pentyl, n-hexyl, 2,2-dimethylbutyl or n-octyl group. The term "polyfluoroalkyl" refers to an alkyl group wherein more than one hydrogen atom is replaced by a fluorine atom.

In a preferred embodiment, the hydrophobic disulfide is a compound of formula $R^1$-S-S-$R^2$, wherein $R^1$ and $R^2$ are independently an (preferably unfunctionalized) alkyl group or a polyfluoroalkyl group. Preferably, the alkyl group is a linear, branched, or cyclic $C_6$-$C_{30}$ alkyl group. It is further preferred that the polyfluoroalkyl group is a branched or linear $C_1$ to $C_{14}$ polyfluoroalkyl group, more preferred is a linear $C_4$ to $C_{12}$ polyfluoroalkyl group (preferably containing from 5 to 25 fluorine atoms). A particularly preferred group $R^1$ and/or $R^2$ is a group of formula $F_3C(CF_2)_7(CH_2)_2$-.

In a further preferred embodiment, the hydrophilic disulfide is a group of formula $R^3$-S-S-$R^4$, wherein $R^3$ and $R^4$ are independently a functionalized alkyl group as defined above. It is preferred that the functionalized alkyl has one functional group. Preferably, the alkyl group is a linear $C_1$ to $C_8$ alkyl group, more preferably a linear $C_2$ or $C_3$ alkyl group. Preferably, the functional group of the linear alkyl group is at the terminal position. Particularly preferred hydrophilic groups $R^3$ and $R^4$ are 2-aminoethyl and 2-mercaptoethyl. Further preferred groups $R^3$ and $R^4$ correspond to the hydrophilic groups of the hydrophilic thiol described above.

The hydrophilic thioether groups and the hydrophobic thioether groups of features (i) and (ii) of the patterned substrate of the present invention are preferably derived from the hydrophilic and hydrophobic thiols or disulfides described above. Accordingly, the hydrophobic thioether groups preferably carry the same preferred (preferably unfunctionalized) alkyl group or polyfluoroalkyl group given above for the hydrophobic thiol. Moreover, the hydrophilic thioether groups preferably carry the same preferred functionalized alkyl group or the other preferred groups given above for the hydrophilic thiol.

Preferably, step (e) is carried out in the absence of UV light, e.g. in the dark.

Between steps (f) and (g) and/or after step (h), surface (B) may be washed with a solvent. Examples of suitable solvents are ethers such as diethyl ether; alcohols such as methanol, ethanol and isopropanol; acetone; ethyl acetate; dichloromethane, dimethylformamide; dimethyl sulfoxide; acetonitrile or mixtures thereof.

According to a preferred embodiment, a photoinitiator is used together with the thiol or disulfide in step (e).

According to a further preferred embodiment, a photoinitiator is used together with the thiol or disulfide in step (g).

According to an even further preferred embodiment described below, a solution of a photoinitiator in a solvent or solvent mixture is used without any thiol in step (e). According to a further preferred embodiment, a photoinitiator solution is added either by spray or spin coating, followed by drying.

Examples of suitable photoinitiators are 2,2-dimethoxy-2-phenylacetophenone, 1-[4-(2-hydroxyethoxy)-phenyl]-2-hydroxy-2-methyl-1-propane-1-one (Irgacure 2959), benzophenone, dimethoxy acetophenone, xanthone, thioxanthone and mixtures thereof.

In step (e), a pure thiol or disulfide as well as a solution thereof may be applied to the surface. It is preferred to use a solution of the thiol or disulfide, wherein the content of the thiol or disulfide preferably is 1 to 50 vol%, more preferably 5 to 30 vol%. Suitable solvents are organic solvents such as acetone, ethanol, ethyl acetate, isopropanol, DCM, THF, methanol, ether, butanol and mixtures thereof.

Further, in step (e) a pure photoinitiator as well as a solution thereof may be applied to the surface. It is preferred to use a solution of the photoinitiator, wherein the concentration of the photoinitiator is preferably between 0,05 and 50%, more preferably between 0,1 and 10%. Suitable solvents are organic solvents such as acetone, ethanol, ethyl acetate, isopropanol, DCM, THF, methanol, ether, butanol and mixtures thereof.

When in step (f) only part of surface (B) is irradiated with UV light, site-selectivity (which leads to the pattern of the final patterned substrate) may be achieved by means of a photomask. Thereby the pattern of the photomask leads to the desired pattern of the final patterned substrate. Further, the site-selectivity may be achieved by the use of a UV laser which is able to selectively irradiate only parts of surface (B) with UV light.

The use of a photomask is preferred. In this case, the method of the present invention preferably comprises step (e1) between steps (e) and (f) and step (f1) after step (f):

(e1) covering part of surface (B) with a photomask having a predetermined pattern;
(f1) removing the photomask.

Preferably, the photomask is removed before step (g) and also before an optional washing step which is carried out between steps (f) and (g).

A suitable photomask has areas of low and high UV-transmittance, and is for example a quartz chromium photomask. Preferably, the distance between the photomask and surface (B) of the substrate is 200 μm or less.

The photomask has preferably a thickness of from 1 to 3 mm (e.g. 2 mm).

UV irradiation (step (f)) is preferably carried out for a duration of 10 seconds to 5 minutes, more preferably 30 seconds to 3 minutes, at 0.5 to 150 mW cm$^{-2}$, more preferably 3 to 150 mW cm$^{-2}$, at a wavelength of 200 to 360 nm, for instance 260 nm.

In step (g), the pure thiol or disulfide or a solution thereof may be applied to the surface. It is preferred to use a solution of the thiol or disulfide, wherein the content of the thiol or disulfide is preferably is 1 to 100 vol%, more preferably 5 to 30 vol%.

The solvent used in step (g) is not particularly limited. Examples of the solvents are alcohols such as e.g. methanol, ethanol, n-propanol, isopropanol, n-butanol and isobutanol; ketones such as acetone, methyl ethyl ketone, methyl isopropyl ketone, methyl isobutyl ketone and cyclohexanone; esters such as methyl acetate, ethyl acetate, n-propyl acetate, isopropyl acetate, butyl acetate and isobutyl acetate; ethers such as diethyl ether, methyl propyl ether, methyl isopropyl ether, methyl butyl ether and methyl tert-butyl ether; and hydrocarbons such as hexane, cyclohexane, heptane, isooctane, toluene, xylene and mineral spirit.

If the thiol in step (e) is hydrophobic, then preferred solvents in step (g) are water and alcohol, such as ethanol, and mixtures thereof. If the thiol in step (e) is hydrophilic or only photoinitiator (no thiol) is used in step (e), then the preferred solvent is not limited to water and ethanol.

With respect to the preferred irradiation conditions for step (h), the same as outlined above with respect to step (f) applies. Further, it is preferred to cover the surface with the hydrophilic or hydrophobic thiol with a quartz slide after step (g) and before step (h).

The preferred features described herein refer to all methods and products of the present invention.

The present invention moreover relates to a method of producing a patterned substrate having hydrophilic areas that are surrounded by hydrophobic areas, comprising the following steps:

(a) providing a composition (A) containing nanoparticles and a trialkoxy or dialkoxyalkyl silane containing a double bond or a triple bond in a solvent;
(b) providing a substrate having a surface (B);
(c) applying the composition (A) onto the surface (B) of the substrate;
(d) drying the substrate carrying the composition (A);
(e) contacting surface (B) with a hydrophobic thiol or a hydrophobic disulfide (especially a hydrophobic thiol);
(f) irradiating surface (B) with UV light, to produce nanoparticles carrying hydrophobic thioether groups on surface (B); and
(g) oxidizing part of surface (B) with UV light or laser light to produce hydrophilic areas on surface (B).

In this method of the present invention, site-selectivity is preferably achieved in step (g) via photomask-dependent UV ablation or laser ablation which is able to create hydrophilic patterns by oxidation.

In the patterned substrate produced according to the above method, the hydrophilic groups comprise an oxidized or hydrophilized alkyl, alkene (e.g. vinyl) or an alkyne groups via the UV light or laser ablation method.

According to a preferred embodiment, steps (a) to (g) are carried out in the order indicated above.

The present invention moreover relates to a method of producing a patterned substrate having hydrophilic areas that are surrounded by hydrophobic areas, comprising the following steps:

(a) providing a composition (A) containing nanoparticles and a trialkoxy or dialkoxyalkyl silane containing a double bond or a triple bond in a solvent;
(b) providing a substrate having a surface (B);
(c) applying the composition (A) onto the surface (B) of the substrate;
(d) drying the substrate carrying the composition (A);
(e) applying a photoinitiator onto surface (B);
(f) irradiating part of surface (B) with UV light or laser light to produce hydrophilic areas on surface (B);

(g) contacting surface (B) with a hydrophobic thiol or a hydrophobic disulfide (especially a hydrophobic thiol);

(h) irradiating surface (B) with UV light, to produce nanoparticles carrying hydrophobic thioether groups on surface (B).

In this method of the present invention, site-selectivity is preferably achieved in step (f) via photomask-dependent UV ablation or laser ablation which is able to create hydrophilic patterns by oxidation.

In the patterned substrate produced according to the above method, the hydrophilic groups comprise an oxidized or hydrophilized alkyl, alkene (e.g. vinyl) or an alkyne groups via the UV light or laser ablation method after contacting the substrate with a solution of a photoinitiator.

It has been found that addition of a photoinitiator is necessary for fast ablation/ hydrophilization of the surface irradiated through a quartz slide, which was not expected by a person skilled in the art. This further improves and accelerates the processing.

According to a preferred embodiment, steps (a) to (h) are carried out in the order indicated above.

The present invention further relates to a method of producing a patterned substrate having hydrophilic areas that are surrounded by hydrophobic areas, comprising the following steps:

(a) providing a composition (A) containing nanoparticles and a trialkoxy or dialkoxyalkyl silane containing a double bond or a triple bond in a solvent;

(b) providing a substrate having a surface (B);

(c) applying the composition (A) onto the surface (B) of the substrate;

(d) drying the substrate carrying the composition (A);

(e) contacting part of surface (B) with a hydrophobic or a hydrophilic thiol or a hydrophobic or a hydrophilic disulfide (especially a hydrophobic or a hydrophilic thiol);

(f) irradiating surface (B) with UV light;

(g) contacting surface (B) with a hydrophilic or a hydrophobic thiol or a hydrophilic or a hydrophobic disulfide (especially a hydrophilic or a hydrophobic thiol); and

(h) irradiating surface (B) with UV light.

In one of steps (e) and (g), surface (B) is contacted with a hydrophobic thiol or disulfide and in the other one of steps (e) and (g), surface (B) is contacted with a hydrophilic thiol or disulfide.

In this method, site-selectivity is preferably achieved in step (e), for example, by microcontact printing, microchannel cantilever spotting or dip pen nanolithography.

According to a preferred embodiment, steps (a) to (h) are carried out in the order indicated above.

Preferably, in step (e) surface (B) is contacted with a hydrophobic thiol or disulfide (especially thiol) and in step (g) surface (B) is contacted with a hydrophilic thiol or disulfide (especially thiol).

The present invention moreover relates to a patterned substrate having hydrophilic areas that are surrounded by hydrophobic areas which is produced according to one of the methods of the present invention.

In a preferred embodiment of the present invention, the patterned substrate is a microarray. In another preferred embodiment of the present invention, the patterned substrate is a microplate having hydrophilic patterns surrounded by the hydrophobic areas. In a more preferred embodiment of the present invention, the patterned substrate is a microplate having 6, 12, 24, 96, 384, 1536, 3456, and 9600 or more hydrophilic areas.

In the present invention, the hydrophilic areas of the patterned substrate are separated by the hydrophobic areas so as to form an array of hydrophilic areas surrounded by the hydrophobic areas.

In a preferred embodiment of the patterned substrate according to the present invention, the hydrophilic areas are separated by the hydrophobic areas so as to form hydrophilic channels. In a more preferred embodiment of the present invention, the patterned substrate comprises hydrophilic channels on a hydrophobic background and the patterned substrate is used for microfluidic applications.

In another preferred embodiment of the present invention, the hydrophilic areas which are separated by the hydrophobic barriers in the patterned substrate have a circular, square, oval, pentagram (star) or polygonal (e.g. triangular, square, pentagonal, hexagonal) shape. Hydrophilic areas having a triangular, hexagonal or a square shape allow dense packing of the areas and ease the readout. Nevertheless, the patterned substrate according to the present invention is not limited to any array-format.

In one embodiment of the present invention, the area-density of the hydrophilic areas is increased. Preferably, the amount of hydrophilic areas is at least 20 per $cm^2$ of the patterned substrate, more preferably at least 30 per $cm^2$ of the patterned substrate. In a particularly preferred embodiment of the present invention, the amount of hydrophilic areas is at least 50 per $cm^2$ of the patterned substrate.

According to an even more preferred embodiment of the present invention, the patterned substrate of the present invention has a size which fits on a standard microtiter scaled plate ($12 \times 8$ cm), preferably a size of about $11 \times 7$ cm with at least 2000, preferably at least 5000 hydrophilic areas separated by hydrophobic background.

Preferably, in the patterned substrate according to the present invention, the overall area-number on the substrate is significantly increased. In a particularly preferred embodiment of the present invention, each of the hydrophilic areas has a side length of 1000 $\mu$m or less, preferably 500 $\mu$m or less, more preferably 400 $\mu$m, 300

μm, 200 μm, 100 μm or less, even more preferably 50 μm or less, particularly under the provision that the hydrophilic areas have a stripe, square or triangular shape. In a further preferred embodiment of the present invention, each of the hydrophilic areas has a side length of 10 μm or more.

In a preferred embodiment of the present invention the hydrophobic barriers have a width of 500 μm or less, preferably 200 μm or less, more preferably 100 μm or less and even more preferably 60 μm or less. In a further preferred embodiment of the present invention, each of the hydrophobic barriers has a width of 10 μm or more. A significant advantage of the patterned substrate according to the present invention is that the hydrophobic barriers completely prevent cross-contamination between the areas, despite the reduced width of the barriers.

According to a further preferred embodiment, the patterned substrate of the present invention has an outer geometry of 70-80 mm × 20-30 mm (e.g. 76 mm × 25 mm) and a thickness of 150 μm to 1 mm. The hydrophilic areas preferably range from 300 μm to 3000 μm feature size and the preferred volume that can be applied to each hydrophilic area ranges from 3 nanoliters to 2 micro-liters.

In general, surface properties can be classified into hydrophobic and hydrophilic surfaces depending on the value of the water contact angle (WCA). Herein, a surface having a static WCA of at least 90° is referred as hydrophobic, whereas a static WCA smaller than 90° is referred to as hydrophilic. In practice, two types of WCA values are used: static and dynamic. Static water contact angles ($\theta_{stat}$) are obtained by sessile drop measurements, where a drop is deposited on the surface and the value is obtained by a goniometer or a specialized software. Dynamic contact angles are non-equilibrium contact angles and are measured during the growth (advancing WCA $\theta_{adv}$) and shrinkage (receding WCA $\theta_{rec}$) of a water droplet. The difference between $\theta_{adv}$ and $\theta_{rec}$ is defined as contact angle hysteresis (CAH).

In a preferred embodiment of the present invention, the hydrophobic areas have a static WCA of at least 90°, preferably greater than 95°, more preferably greater than 100°, further preferably greater than 110°, more preferably greater than 130°, most preferably greater than 145°.

The sliding angle is a measure of the mobility of a drop on the surface. The sliding angle of a surface can be determined by dropping 4 μL of a specific liquid (such as water, hexane, etc.) on the hydrophilic or hydrophobic area of the substrate and incrementally tilting the substrate in steps of 1°. The angle at which the drop starts to slide is taken as sliding angle.

In a preferred embodiment, the sliding angle of a specific liquid (such as water) on the hydrophobic surface is at most 15°, preferably at most 10°, most preferably at most 5°. The hydrophobic surface shows dewetting ability to various liquids. Droplets (of water, an organic liquid such as hexadecane, or DMSO, etc.) do not stick to such surfaces and easily slide off. In a preferred embodiment of the present invention, hydrophilic areas have a static WCA less than 20°, preferably less than 10°, more preferably less than 5°, most preferably close to or of 0°. The hydrophilic surface shows wetting ability to various liquids. Droplets (of water, an organic liquid such as hexane, etc.) are absorbed by such surfaces.

The development of a microdroplet array on a transparent substrate is essential for a range of applications, such as high-throughput screenings using optical detection methods, microscopy, or UV-Vis absorption spectroscopy. One of the biggest drawbacks associated with superhydrophobic and superomniphobic coatings of the prior art is their poor transparency due to light scattering. In contrast, the transmittance of the substrate prior to creating the hydrophilic and hydrophobic areas essentially remains unchanged. Preferably, the transmittance drops by less than 10%, preferably by less than 1%. The drop of the transmittance is calculated as follows:

$$100\ \% \cdot (T_0 - T_1) / T_0$$

$T_0$: transmittance of the substrate provided in step (b) of the present invention

$T_1$: transmittance of the substrate after having created the hydrophilic and hydrophobic areas

In a preferred embodiment, the transmittance of the patterned substrate is at least 75%, preferably at least 80% in the visible light range (300 to 700 nm).

The patterned substrate of the present invention is inter alia characterized by the following advantageous properties which are superior over known patterned substrates:

- it has a more homogeneous surface (no stripes caused by taping);
- it has a more homogeneous thickness;
- it shows a better transparency;
- the production time is faster and the production of the substrate is cheaper; and
- it shows less capture of pre-printed drugs which leads to a more precise effect on cells which is comparable to MTP plates.

EXAMPLES

Example 1:

Silica sol solution preparation:

0.25 g Silica nanoparticles (Aerosil 200) were mixed with ethanol (30 mL) and sonicated for 30 minutes. Then vinyl trimethoxysilane (0.33 g) was added along with 200 μl concentrated HCl (37%) and the mixture was sonicated for another 60 minutes. The solution was aged for 24 h before usage.

Spin coating and curing:

The silica sol solution was spin-coated onto activated glass slide (75,6 × 25 × 1 mm) by applying 500 ul solution on the slide and spinning for 15 seconds at 1500 rpm. This was repeated 5 times and the slides were cured at 200°C for 1 hour.

Hydrophobic modification of the coated glass slides was performed by wetting them with a solution of 1H, 1H,2H,2H perfluorodecanethiol (in acetone, 10 vol.%) and then covering them with a quartz plate. The covered glass slides were immediately irradiated with UV light (260 nm, ~5 mW/cm$^2$) for 30 s. After irradiation, the quartz plates were removed and the surfaces were extensively cleaned with ethanol and dried with a nitrogen gun.

Hydrophilic modification of the the coated glass slides was performed by wetting them with a cysteamine solution (in ethanol, 10 wt%) then covering them with a quartz plate. The covered glass slides were immediately irradiated with UV light (260 nm, ~5 mW/cm$^2$) for 30 s. After irradiation, the quartz plates were removed and the surfaces were extensively cleaned with ethanol and dried with nitrogen gun.

The glass slides that were modified by 1H,1H,2H,2H perfluorodecanethiol displayed a WCA of 154 ±1.5° and a water droplet sliding angle of 2.4 ±0.5°.

The glass slides that were modified by cysteamine displayed a WCA of <10° and a sliding angle of >90°.

This example shows that the vinyl silica gel coated surfaces are readily reactive towards thiols under UV irradiation.

The transparency of the slides was measured with a HR2000+ high resolution spectrometer (Ocean Optics Inc., USA) equipped with DH-2000-BAL light source (Mikropack GmbH, Germany). Thereby it was found that the transparency of the vinyl silica gel coated glass slides is almost indistinguishable from the raw glass substrate. They are highly transparent with transmittance above 90% in the visible light range.

Example 2:

The above-described procedure was used to produce vinyl silica gel coated glass slides. The vinyl silica gel coated glass slide was wetted with a 1H,1H,2H,2H-perfluorodecanethiol solution (in acetone, 10 vol.%) and then irradiated with UV light (260 nm, ~5 mW/cm$^2$) through a photomask for 30 s. Thereby different photomasks having different patterns were used (e.g. having an array of circles or squares having a diameter, or edge length, respectively, of 1 mm).

After the first modification, the surfaces were washed with acetone three times and dried under an air flow.

To perform the second modification, the surface was wetted with a 2-mercaptoethanol solution (in 1:1 ethanol/water, 10 vol.%). The wetted surface was then covered with a quartz slide and irradiated with UV light (without photomask) for 30 s. After irradiation, the surface was cleaned with ethanol three times and dried under an air flow.

By this procedure, superhydrophilic-superhydrophobic patterns with different shapes and dimensions were successfully formed on the vinyl silica gel coated glass slides. Uniform microdroplet arrays were obtained.

Further, the possibility of using the superhydrophilic-superhydrophobic patterns on vinyl silica gel coated glass slide for cell culture was investigated:

HeLa cells were seeded onto the patterns. A pattern of squares having an edge-length of 1 mm with 3 fields was used. Cells were seeded in concentration 25×10$^4$ cells/mL using method of standing droplet for 60 seconds. Thereby, it was found that the cells adhered well to the superhydrophilic spots showing its biocompatibility and nontoxicity, while almost no cells occupied the superhydrophobic border.

Moreover, the surface morphology of the vinyl silica gel coated glass slide was investigated:

SEM images were obtained using the LEO 1530 Gemini scanning electron microscope (Zeiss, Germany) at the Institute of Nanotechnology (INT), KIT. Prior to SEM measurements, the samples were sputtered with a 10 nm gold layer using a Cressington 108 auto sputter coater (INT, KIT). Thereby, a highly porous structure was observed on the vinyl silica gel coated glass slides, and hierarchical surface roughness based on primary particle and their aggregates can be clearly seen.

In addition, the resolution of chemical patterning on the vinyl silica gel coated glass slides was investigated:

Vinyl silica gel coated glass slides were wetted with thiol modified fluorescein isothiocyanate (FITC-SH) solution (in acetone, 0.1 wt%) and then covered with a photomask. The covered glass slides were immediately irradiated with UV light (260 nm, ~5 mW/cm2) for 30 s. After irradiation, the photomask was removed and the surfaces were extensively cleaned with ethanol and dried with nitrogen gun.

From a fluorescence microscope image of the FITC-thiol patterns on the vinyl silica gel coated surface it can be taken that the resolution of chemical patterning on the vinyl silica gel coated surface can be as low as 10 μm, which is the lower limit of the photomask.

Further, the chemical stability of the superhydrophilic-superhydrophobic patterns on vinyl silica gel coated glass slide was investigated:

The superhydrophilic-superhydrophobic patterned glass slides were immersed in various solvents including ethanol, acetone, dimethylformamid (DMF), dichloromethane (DCM) and dimethyl sulfoxide (DMSO) for 24 h. After this, the slides were taken out and dried with nitrogen gun. It was found that the superhydrophilic-superhydrophobic patterns were stable in those organic solvents after 24 h immersion.

Moreover, the chemical patterning process on vinyl silica gel coated slides was investigated by ToF-SIMS:

ToF-SIMS (ION TOF Inc., Munster, Germany) was performed at IFG, KIT. The analysis chamber was held at ~8×10⁻⁹ mbar during the experiment. A pulsed 25 keV Bi1 + primary ion beam was used for all image and spectral data acquisition. All data were collected in high mass resolution bunched mode. It was found that the chemical pattern formation with various functional groups was confirmed by ToF-SIMS. The 3D profile showed that the patterning process was conducted throughout the entire layer of the silica gel coating.

Further, the post modification process on vinyl silica gel coated slides was investigated by XPS:

XPS measurements were performed using a K-Alpha+ XPS spectrometer (ThermoFisher Scientific, East Grinstead, UK). It was found that the thiol groups were chemically bonded to the vinyl silica gel coated surface via UV induced thiol-ene click reaction, and not by physical adsorption.

Example 3:

Preparation of composition (A):

750 mg Aerosil 200 silica nano particles were mixed with 90 ml Ethanol. The solution was heated to 60°C and treated with an ultrasonic sonotrode at an intensity of 26J/s for 30 min. Then, 600 μl concentrated HCl and 1220 μl trimethoxyvinylsilane were added to this solution. The solution was treated with an ultrasonic sonotrode at an intensity of 26J/s for 60 min. The final solution was stored for 18 to 24 h in the dark.

Applying composition (A) onto a substrate:

Composition (A) was applied onto a surface (B) of a glass-slide by spin coating. Thereby, the solution was pipetted onto the stationary glass-slide. Then, the glass-slide was rotated for 15 s at 1000 rpm. This procedure was repeated five times. Afterwards, the chamber of the spin coater was flushed with nitrogen.

Drying of the substrate:

After the spin coating, the glass-slide was immediately placed onto a heating plate having a temperature of 130°C. Thereby, the glass-slide was placed onto a frame holding the glass slide at a distance of from 1 to 2 mm from the heating plate, whereby surface (B) of the glass-slide points towards the heating plate. Then, a lid was closed over the heating plate in order to ensure a constant air temperature and the glass-slide was dried for 60 min (45 to 75 min).

Functionalization of the nano particle layer:

A solution of 400 μL 1H,1H,2H,2H-perfluorodecanethiol (10% in acetone + 1% 2,2-dimethoxy-2-phenylacetophenone) was applied onto surface (B) of the glass-slide carrying a layer of composition (A). The liquid film was spread over surface (B) of the glass-slide without air bubbles being trapped therein. Then, surface (B) of the glass-slide was covered with a photomask having the desired pattern (array). The slide was placed into a frame which allowed the precise placing of the photomask. The slide was irradiated with UV light (λ =260 nm) having an intensity of 3 mW/cm² (2 mW/cm² - 10 mW/cm²) for 35 s. Then, the photomask was removed and the slide was washed with acetone and isopropanol in the dark.

Next, a solution of 400 μL 2-mercaptoethanol (10% in ethanol/water (1:1) + 1% Irgacure 2959) was applied onto surface (B) of the glass-slide which was still fixed in the frame and surface (B) was covered with a quartz glass plate. The liquid film was spread over surface (B) of the glass-slide without air bubbles being trapped therein.

The slide was irradiated with UV light (λ =260 nm) having an intensity of 3 mW/cm² (2 mW/cm² - 10 mW/cm²) for 60 s. Then the quartz glass plate was removed and the slide was washed with ethanol in the dark.

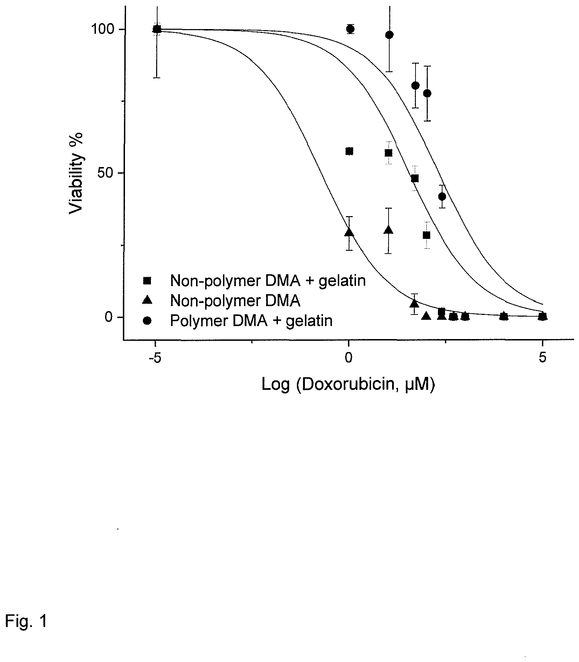

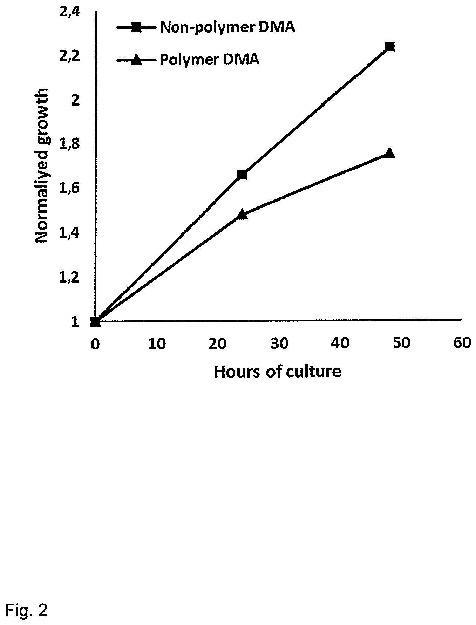

A comparison of the new non-polymer DMA with a state-of-the-art polymer DMA is shown in Figures 1 and 2 and in Table 1. Therein, "Non-polymer DMA" refers to a substrate which is produced as described in example 3. "Polymer DMA" refers to surfaces coated with a HEMA-EDMA polymer as published in Popova et al. "Droplet-Array (DA) Sandwich Chip: A Versatile Platform for High-Throughput Cell Screening Based on Superhydrophobic-Superhydrophilic Micropatterning", Adv. Mater. 2015, 27, 5217-5222 (DOI: 10.1002/adma.201502115).

Figure 1 shows a comparison of dose-response curves showing the effect of doxorubicin on Jurkat cells cultured on different surfaces. Jurkat cells were treated with anti-cancer drug doxorubicin on DMAs containing different surfaces and coatings ((1) non-polymer surface with gelatine coating, (2) non-polymer surface without coating, (3) polymer surface with gelatine coating, which is necessary for culturing of cells on polymer, but not on non-polymer surface). Cells were cultured in 100 nL droplets volume and 100 cells per droplet on 1 mm square hydrophilic spots. Cells were incubated with drug for 24 hours. Afterwards cells were stained with Calcein AM (stains live cells) and Propidium Iodide (stains dead cells) to estimate viability of cells. DMAs were imaged using Olympus IX microscope. Image analysis was performed in Imaged software.

Table 1 shows $IC_{50}$ values of doxorubicin in state-of-the-art microtiter plates and on different surfaces. $IC_{50}$ values were calculated in Origin software by fitting the dose-response curves shown in (a).

Figure 2 shows a comparison of growth curves of Jurkat cultured on polymer and non-polymer surfaces.

Jurkat cells were cultured on non-polymer and polymer surfaces in 100 nL droplets volume and 100 cells per droplet on 1 mm square hydrophilic spots for 48 hours. Images of cells were taken at 0, 24 and 48 hours after seeding. Number of cells in each spot was calculated and plotted.

Table 1:

| Surface | $IC_{50}$ ($\mu$M) |
|---|---|
| Microtiter plate | 0.2 |
| Non-polymer DMA | 0.19 |
| Non-polymer DMA / gelatin | 35.20 |
| Polymer DMA / gelatin | 202.51 |

Example 4:

Preparation of composition (A):

750 mg Aerosil 200 silica nano particles were mixed with 90 ml Ethanol. The solution was heated to 60°C and treated with an ultrasonic sonotrode at an intensity of 26J/s for 30 min. Then, 600 $\mu$l concentrated HCl and 1220 $\mu$l trimethoxyvinylsilane were added to this solution. The solution was treated with an ultrasonic sonotrode at an intensity of 26J/s for 60 min. The final solution was stored for 18 to 24 h in the dark.

Applying composition (A) onto a substrate:

Composition (A) was applied onto a surface (B) of a glass-slide by spray coating. Thereby, 100 $\mu$L of the solution was sprayed onto the stationary glass-slide.

Drying of the substrate:

After the coating, the glass-slide was immediately placed onto a heating plate having a temperature of 150°C. Thereby, the glass-slide was placed directly on the heating plate. Then, a lid was closed over the heating plate in order to ensure a constant air temperature and the glass-slide was dried for 60 min (45 to 75 min).

Functionalization of the nano particle layer:

A solution of 100 $\mu$L Irgacure 2959 (0,1% in ethanol) was applied onto surface (B) of the glass-slide carrying a layer of composition (A) by spin coating which led to the evaporation of the solvent. Then, surface (B) of the glass-slide was covered with a photomask having the desired pattern (array). The slide was placed into a frame which allowed the precise placing of the photomask. The slide was irradiated with UV light ($\lambda$ =260 nm) having an intensity of 150 mW/cm$^2$ for 180 s. Then, the photomask was removed and the slide was washed with ethanol.

A solution of 400 $\mu$L 1H,1H,2H,2H-perfluorodecanethiol (10% in acetone + 1% 2,2-dimethoxy-2-phenylacetophenone) was spray coated onto surface (B) of the glass-slide carrying a layer of composition (A) which led to the evaporation of the solvent. Then, surface (B) of the glass-slide was placed into a frame and was covered with a quartz glass slide having a distance to the substrate of 100 $\mu$m. The slide was irradiated with UV light ($\lambda$ =260 nm) having an intensity of 3 mW/cm$^2$ (2 mW/cm$^2$ - 10 mW/cm$^2$) for 35 s. Then, the photomask was removed and the slide was washed with acetone and isopropanol.

**Claims**

1.  A patterned substrate including a surface having a patterned coating, the patterned coating comprising:

    (i) hydrophilic areas including nanoparticles carrying hydrophilic groups; surrounded by
    (ii) hydrophobic areas including nanoparticles carrying hydrophobic thioether groups;

    wherein the nanoparticles are silica nanoparticles, alumina nanoparticles, titania nanoparticles or zinc oxide nanoparticles.

2.  The patterned substrate according to claim 1, wherein the hydrophilic groups comprise a functionalized alkyl group, wherein "functionalized" means that the alkyl group may have one or more functional groups, which preferably are selected from the group consisting of amine (NH$_2$), hydroxyl (OH), carboxyl (CO$_2$H) and sulfonyl hydroxide (SOsH);

    or, in case the hydrophilic groups are hydrophilic thioether groups, wherein the hydrophilic groups are derived from the amino acid cysteine, cysteine-containing hydrophilic proteins, cysteine-containing hydrophilic peptides, thiol-containing sugars, thiol-PEG, or thiol-bearing PVA polymer, and thiol-polysaccharides; or wherein the hydrophilic groups are derived from a thiol functionalized biomolecule, such as biotin-PEG-SH;
    and wherein the hydrophobic thioether groups comprise an alkyl group or a polyfluoroalkyl group, wherein the alkyl group is preferably a linear, branched, or cyclic C$_6$-C$_{30}$ alkyl group and wherein the polyfluoroalkyl group is preferably a branched or linear C$_1$ to C$_{14}$ polyfluoroalkyl group, more preferred is a linear C$_4$ to C$_{12}$ polyfluoroalkyl group.

3.  A method of producing a patterned substrate having hydrophilic areas that are surrounded by hydrophobic areas, comprising the following steps:

(a) providing a composition (A) containing nanoparticles and a trialkoxy or dialkoxyalkyl silane containing a double bond or a triple bond in a solvent;
(b) providing a substrate having a surface (B);
(c) applying the composition (A) onto the surface (B) of the substrate;
(d) drying the substrate carrying the composition (A);
(e) contacting surface (B) with a hydrophobic or a hydrophilic thiol or a hydrophobic or a hydrophilic disulfide;
(f) irradiating part of surface (B) with UV light;
(g) contacting surface (B) with a hydrophilic or a hydrophobic thiol or a hydrophilic or a hydrophobic disulfide; and
(h) irradiating surface (B) with UV light;
wherein in one of steps (e) and (g), surface (B) is contacted with a hydrophobic thiol or disulfide and in the other one of steps (e) and (g), surface (B) is contacted with a hydrophilic thiol or disulfide;
wherein the nanoparticles are silica nanoparticles, alumina nanoparticles, titania nanoparticles or zinc oxide nanoparticles.

4. A method of producing a patterned substrate having hydrophilic areas that are surrounded by hydrophobic areas, comprising the following steps:

(a) providing a composition (A) containing nanoparticles and a trialkoxy or dialkoxyalkyl silane containing a double bond or a triple bond in a solvent;
(b) providing a substrate having a surface (B);
(c) applying the composition (A) onto the surface (B) of the substrate;
(d) drying the substrate carrying the composition (A);
(e) contacting surface (B) with a hydrophobic thiol or a hydrophobic disulfide;
(f) irradiating surface (B) with UV light, to produce nanoparticles carrying hydrophobic thioether groups on surface (B); and
(g) oxidizing part of surface (B) with UV light or laser light to produce hydrophilic areas on surface (B);

wherein the nanoparticles are silica nanoparticles, alumina nanoparticles, titania nanoparticles or zinc oxide nanoparticles.

5. A method of producing a patterned substrate having hydrophilic areas that are surrounded by hydrophobic areas, comprising the following steps:

(a) providing a composition (A) containing nanoparticles and a trialkoxy or dialkoxyalkyl silane containing a double bond or a triple bond in a solvent;
(b) providing a substrate having a surface (B);
(c) applying the composition (A) onto the surface (B) of the substrate;
(d) drying the substrate carrying the composition (A);
(e) contacting part of surface (B) with a hydrophobic or a hydrophilic thiol or a hydrophobic or a hydrophilic disulfide;
(f) irradiating surface (B) with UV light;
(g) contacting surface (B) with a hydrophilic or a hydrophobic thiol or a hydrophilic or a hydrophobic disulfide; and
(h) irradiating surface (B) with UV light;
wherein in one of steps (e) and (g), surface (B) is contacted with a hydrophobic thiol or disulfide and in the other one of steps (e) and (g), surface (B) is contacted with a hydrophilic thiol or disulfide;
wherein the nanoparticles are silica nanoparticles, alumina nanoparticles, titania nanoparticles or zinc oxide nanoparticles.

6. A method of producing a patterned substrate having hydrophilic areas that are surrounded by hydrophobic areas, comprising the following steps:

(a) providing a composition (A) containing nanoparticles and a trialkoxy or dialkoxyalkyl silane containing a double bond or a triple bond in a solvent;
(b) providing a substrate having a surface (B);
(c) applying the composition (A) onto the surface (B) of the substrate;
(d) drying the substrate carrying the composition (A);
(e) applying a photoinitiator onto surface (B);
(f) irradiating part of surface (B) with UV light or laser light;
(g) contacting surface (B) with a hydrophobic thiol or a hydrophobic disulfide;
(h) irradiating surface (B) with UV light;

wherein the nanoparticles are silica nanoparticles, alumina nanoparticles, titania nanoparticles or zinc oxide nanoparticles.

7. The method according to claim 3 or 6, wherein in step (f) the site-selectivity is achieved by means of a photomask or by the use of a UV laser which is able to selectively irradiate only part of surface (B) with UV light.

8. The method according to claim 3, 6 or 7, wherein in step (f) the site-selectivity is achieved by means of a photomask and wherein the method further comprises step (e1) between steps (e) and (f) and step (f1) after step (f):

(e1) covering part of surface (B) with a photomask having a predetermined pattern; and
(f1) removing the photomask.

9. The method according to claim 5, wherein site-selectivity is achieved in step (e), by microcontact printing, microchannel cantilever spotting or dip pen nanolithography.

10. The method according to any one of claims 3 to 9, wherein the trialkoxy or dialkoxyalkyl silane containing a double bond or a triple bond is selected from trialkoxyvinylsilanes and dialkoxyalkylvinylsilanes.

11. The method according to any one of claims 3 to 10, wherein the solvent used in composition (A) is an alcohol, a ketone, an ester or a hydrocarbon.

12. The method according to any one of claims 3 to 11, wherein the substrate is made from glass, plastic, ITO (indium-tin-oxide), silicon, quartz, COC (cyclic olefin copolymer), PS (polystyrene), PMMA (Poly(methyl methacrylate)), paper, cellulose or metal, and wherein the substrate is in the form of a slide, a wafer, a plate, a film or a sheet.

13. The method according to any one of claims 3 to 12, wherein in step (c) the composition (A) is applied onto surface (B) by spin coating, dip coating or spray coating.

14. The method according to any one of claims 3 to 13, wherein the hydrophobic thiol is represented by formula R-SH and the hydrophobic disulfide is represented by formula $R^1$-S-S-$R^2$, wherein R, $R^1$ and $R^2$ are independently an alkyl group or a polyfluoroalkyl group, wherein the alkyl group is preferably a linear, branched, or cyclic $C_6$-$C_{30}$ alkyl group and wherein the polyfluoroalkyl group is preferably a branched or linear $C_1$ to $C_{14}$ polyfluoroalkyl group, more preferred is a linear $C_4$ to $C_{12}$ polyfluoroalkyl group.

15. The method according to any one of claims 3, 5 and 7 to 13, wherein the hydrophilic thiol is represented by formula R'-SH and the hydrophilic disulfide is represented by formula $R^3$-S-S-$R^4$, wherein R', $R^3$ and $R^4$ are independently a functionalized alkyl group, wherein "functionalized" means that the alkyl group may have one or more functional groups, which preferably are selected from the group consisting of amine ($NH_2$), hydroxyl (OH), carboxyl ($CO_2$H) and sulfonyl hydroxide (SOsH); or wherein the hydrophilic thiol is selected from the amino acid cysteine, cysteine-containing hydrophilic proteins, cysteine-containing hydrophilic peptides, thiol-containing sugars, thiol-PEG, or thiol-bearing PVA polymer, and thiol-polysaccharides; or wherein the hydrophilic thiol is a thiol functionalized biomolecule, such as biotin-PEG-SH.

16. A patterned substrate according to claim 1, having hydrophilic areas that are surrounded by hydrophobic areas which is produced according to the method of any one of claims 3 to 15.

**Patentansprüche**

1. Gemustertes Substrat mit einer Oberfläche, die eine gemusterte Beschichtung aufweist, wobei die gemusterte Beschichtung umfasst:

(i) hydrophile Bereiche, einschließlich Nanopartikel, die hydrophile Gruppen tragen; umgeben von
(ii) hydrophoben Bereichen, einschließlich Nanopartikeln, die hydrophobe Thioethergruppen tragen;

wobei die Nanopartikel Siliziumdioxid-Nanopartikel, Aluminiumoxid-Nanopartikel, Titandioxid-Nanopartikel oder Zinkoxid-Nanopartikel sind.

2. Gemustertes Substrat nach Anspruch 1, wobei die hydrophilen Gruppen eine funktionalisierte Alkylgruppe umfassen, wobei "funktionalisiert" bedeutet, dass die Alkylgruppe eine oder mehrere funktionelle Gruppen aufweisen kann, die vorzugsweise aus der Gruppe bestehend aus Amin ($NH_2$), Hydroxyl (OH), Carboxyl ($CO_2$H) und Sulfonylhydroxid (SOsH) ausgewählt sind;
oder, falls es sich bei den hydrophilen Gruppen um hydrophile Thioethergruppen handelt, wobei die hydrophilen Gruppen von der Aminosäure Cystein, cysteinhaltigen hydrophilen Proteinen, cysteinhaltigen hydrophilen Peptiden, thiolhaltigen Zuckern, Thiol-PEG oderthiolhaltigem PVA-Polymer und Thiol-Polysacchariden abgeleitet sind; oder wobei die hydrophilen Gruppen von einem thiolfunktionalisierten Biomolekül, wie Biotin-PEG-SH, abgeleitet sind; und wobei die hydrophoben Thioethergruppen eine Alkylgruppe oder eine Polyfluoralkylgruppe umfassen, wobei die Alkylgruppe vorzugsweise eine lineare, verzweigte oder zyklische $C_6$-$C_{30}$ Alkylgruppe ist und wobei die Polyfluoralkylgruppe vorzugsweise eine verzweigte oder lineare $C_1$ bis $C_{14}$ Polyfluoralkylgruppe ist, bevorzugter eine lineare $C_4$ bis $C_{12}$ Polyfluoralkylgruppe ist.

3. Verfahren zur Herstellung eines gemusterten Substrats mit hydrophilen Bereichen, die von hydrophoben Bereichen umgeben sind, umfassend die folgenden Schritte:

(a) Bereitstellen einer Zusammensetzung (A), die Nanopartikel und ein Trialkoxy- oder Dialkoxyalkylsilan, das eine Doppelbindung oder eine Dreifachbindung enthält, in einem Lösungsmittel enthält;
(b) Bereitstellung eines Substrats mit einer Oberfläche (B);
(c) Auftragen der Zusammensetzung (A) auf die Oberfläche (B) des Substrats;
(d) Trocknen des Substrats, das die Zusammensetzung (A) trägt;
(e) Inkontaktbringen der Oberfläche (B) mit einem hydrophoben oder hydrophilen Thiol oder einem hydrophoben oder hydrophilen Disulfid;
(f) Bestrahlung eines Teils der Oberfläche (B) mit UV-Licht;
(g) Inkontaktbringen der Oberfläche (B) mit einem hydrophilen oder hydrophoben Thiol oder einem hydrophilen oder hydrophoben Disulfid; und
(h) Bestrahlung der Oberfläche (B) mit UV-Licht; wobei in einem der Schritte (e) und (g) die Oberfläche (B) mit einem hydrophoben Thiol oder Disulfid und in dem anderen der Schritte (e) und (g) die Oberfläche (B) mit einem hydrophilen Thiol oder Disulfid in Kontakt gebracht wird; wobei die Nanopartikel Siliziumdioxid-Nanopartikel, Aluminiumoxid-Nanopartikel, Titandioxid-Nanopartikel oder Zinkoxid-Nanopartikel sind.

4. Verfahren zur Herstellung eines gemusterten Substrats mit hydrophilen Bereichen, die von hydrophoben Bereichen umgeben sind, umfassend die folgenden Schritte:

    (a) Bereitstellen einer Zusammensetzung (A), die Nanopartikel und ein Trialkoxy- oder Dialkoxyalkylsilan, das eine Doppelbindung oder eine Dreifachbindung enthält, in einem Lösungsmittel enthält;
    (b) Bereitstellung eines Substrats mit einer Oberfläche (B);
    (c) Auftragen der Zusammensetzung (A) auf die Oberfläche (B) des Substrats;
    (d) Trocknen des Substrats, das die Zusammensetzung (A) trägt;
    (e) Inkontaktbringen der Oberfläche (B) mit einem hydrophoben Thiol oder einem hydrophoben Disulfid;
    (f) Bestrahlung der Oberfläche (B) mit UV-Licht, um Nanopartikel zu erzeugen, die hydrophobe Thioethergruppen auf der Oberfläche (B) tragen; und
    (g) Oxidieren eines Teils der Oberfläche (B) mit UV-Licht oder Laserlicht, um hydrophile Bereiche auf der Oberfläche (B) zu erzeugen;

wobei die Nanopartikel Siliziumdioxid-Nanopartikel, Aluminiumoxid-Nanopartikel, Titandioxid-Nanopartikel oder Zinkoxid-Nanopartikel sind.

5. Verfahren zur Herstellung eines gemusterten Substrats mit hydrophilen Bereichen, die von hydrophoben Bereichen umgeben sind, umfassend die folgenden Schritte:

    (a) Bereitstellen einer Zusammensetzung (A), die Nanopartikel und ein Trialkoxy- oder Dialkoxyalkylsilan, das eine Doppelbindung oder eine Dreifachbindung enthält, in einem Lösungsmittel enthält;
    (b) Bereitstellung eines Substrats mit einer Oberfläche (B);
    (c) Auftragen der Zusammensetzung (A) auf die Oberfläche (B) des Substrats;
    (d) Trocknen des Substrats, das die Zusammensetzung (A) trägt;
    (e) Inkontaktbringen eines Teils der Oberfläche (B) mit einem hydrophoben oder hydrophilen Thiol oder einem hydrophoben oder hydrophilen Disulfid;
    (f) Bestrahlung der Oberfläche (B) mit UV-Licht;
    (g) Inkontaktbringen der Oberfläche (B) mit einem hydrophilen oder hydrophoben Thiol oder einem hydrophilen oder hydrophoben Disulfid; und
    (h) Bestrahlung der Oberfläche (B) mit UV-Licht; wobei in einem der Schritte (e) und (g) die Oberfläche (B) mit einem hydrophoben Thiol oder Disulfid und in dem anderen der Schritte (e) und (g) die Oberfläche (B) mit einem hydrophilen Thiol oder Disulfid in Kontakt gebracht wird; wobei die Nanopartikel Siliziumdioxid-Nanopartikel, Aluminiumoxid-Nanopartikel, Titandioxid-Nanopartikel oder Zinkoxid-Nanopartikel sind.

6. Verfahren zur Herstellung eines gemusterten Substrats mit hydrophilen Bereichen, die von hydrophoben Bereichen umgeben sind, umfassend die folgenden Schritte:

    (a) Bereitstellen einer Zusammensetzung (A), die Nanopartikel und ein Trialkoxy- oder Dialkoxyalkylsilan, das eine Doppelbindung oder eine Dreifachbindung enthält, in einem Lösungsmittel enthält;
    (b) Bereitstellung eines Substrats mit einer Oberfläche (B);
    (c) Auftragen der Zusammensetzung (A) auf die Oberfläche (B) des Substrats;
    (d) Trocknen des Substrats, das die Zusammensetzung (A) trägt;
    (e) Auftragen eines Photoinitiators auf die Oberfläche (B);
    (f) Bestrahlung eines Teils der Oberfläche (B) mit UV-Licht oder Laserlicht;

(g) Inkontaktbringen der Oberfläche (B) mit einem hydrophoben Thiol oder einem hydrophoben Disulfid;

(h) Bestrahlung der Oberfläche (B) mit UV-Licht;

wobei die Nanopartikel Siliziumdioxid-Nanopartikel, Aluminiumoxid-Nanopartikel, Titandioxid-Nanopartikel oder Zinkoxid-Nanopartikel sind.

**7.** Verfahren nach Anspruch 3 oder 6, wobei in Schritt (f) die Ortsselektivität mittels einer Fotomaske oder durch die Verwendung eines UV-Lasers erreicht wird, der in der Lage ist, nur einen Teil der Oberfläche (B) selektiv mit UV-Licht zu bestrahlen.

**8.** Verfahren nach Anspruch 3, 6 oder 7, wobei in Schritt (f) die Ortsselektivität mit Hilfe einer Photomaske erreicht wird und wobei das Verfahren ferner Schritt (e1) zwischen den Schritten (e) und (f) und Schritt (f1) nach Schritt (f) umfasst:

(e1) Bedecken eines Teils der Oberfläche (B) mit einer Fotomaske mit einem vorgegebenen Muster; und
(f1) Entfernen der Fotomaske.

**9.** Verfahren nach Anspruch 5, wobei die Ortsselektivität in Schritt (e) durch Mikrokontaktdruck, Mikrokanal-Cantilever-Spotting oder Dip Pen-Nanolithographie erreicht wird.

**10.** Verfahren nach einem der Ansprüche 3 bis 9, wobei das Trialkoxy- oder Dialkoxyalkylsilan, das eine Doppelbindung oder eine Dreifachbindung enthält, aus Trialkoxyvinylsilanen und Dialkoxyalkylvinylsilanen ausgewählt ist.

**11.** Verfahren nach einem der Ansprüche 3 bis 10, wobei das in der Zusammensetzung (A) verwendete Lösungsmittel ein Alkohol, ein Keton, ein Ester oder ein Kohlenwasserstoff ist.

**12.** Verfahren nach einem der Ansprüche 3 bis 11, wobei das Substrat aus Glas, Kunststoff, ITO (Indium-Zinn-Oxid), Silizium, Quarz, COC (Cyclic Olefin Copolymer), PS (Polystyrol), PMMA (Poly(methylmethacrylat)), Papier, Zellulose oder Metall hergestellt wurde und wobei das Substrat in Form eines Objektträgers, eines Wafers, einer Platte, eines Films oder einer Folie vorliegt.

**13.** Verfahren nach einem der Ansprüche 3 bis 12, wobei in Schritt (c) die Zusammensetzung (A) durch Schleuderbeschichtung, Tauchbeschichtung oder Sprühbeschichtung auf die Oberfläche (B) aufgebracht wird.

**14.** Verfahren nach einem der Ansprüche 3 bis 13, wobei das hydrophobe Thiol durch die Formel R-SH dargestellt wird und das hydrophobe Disulfid durch die Formel $R^1$-S-S-$R^2$ dargestellt wird, wobei R, $R^1$ und $R^2$ unabhängig eine Alkylgruppe oder eine Polyfluoralkylgruppe sind, wobei die Alkylgruppe vorzugsweise eine lineare, verzweigte oder zyklische $C_6$-$C_{30}$ Alkylgruppe ist und wobei die Polyfluoralkylgruppe vorzugsweise eine verzweigte oder lineare $C_1$ bis $C_{14}$ Polyfluoralkylgruppe ist, bevorzugter ist eine lineare $C_4$ bis $C_{12}$ Polyfluoralkylgruppe.

**15.** Verfahren nach einem der Ansprüche 3, 5 und 7 bis 13, wobei das hydrophile Thiol durch die Formel R'-SH dargestellt wird und das hydrophile Disulfid durch die Formel $R^3$-S-S-$R^4$ dargestellt wird, wobei R', $R^3$ und $R^4$ unabhängig voneinander eine funktionalisierte Alkylgruppe sind, wobei "funktionalisiert" bedeutet, dass die Alkylgruppe eine oder mehrere funktionelle Gruppen aufweisen kann, die vorzugsweise ausgewählt sind aus der Gruppe bestehend aus Amin ($NH_2$), Hydroxyl (OH), Carboxyl ($CO_2H$) und Sulfonylhydroxid ($SO_3H$); oder wobei das hydrophile Thiol ausgewählt ist aus der Aminosäure Cystein, cysteinhaltigen hydrophilen Proteinen, cysteinhaltigen hydrophilen Peptiden, thiolhaltigen Zuckern, Thiol-PEG oder thiolhaltigem PVA-Polymer und Thiol-Polysacchariden; oder wobei das hydrophile Thiol ein thiolfunktionalisiertes Biomolekül ist, wie Biotin-PEG-SH.

**16.** Gemustertes Substrat nach Anspruch 1 mit hydrophilen Bereichen, die von hydrophoben Bereichen umgeben sind, das nach dem Verfahren nach einem der Ansprüche 3 bis 15 hergestellt ist.

**Revendications**

**1.** Substrat à motifs comprenant une surface avec un revêtement à motifs, le revêtement à motifs comprenant:

(i) des zones hydrophiles, y compris des nanoparticules portant des groupes hydrophiles, entourées de
(ii) des zones hydrophobes, y compris des nanoparticules portant des groupes thioéthers hydrophobes;

dans lequel les nanoparticules sont des nanoparticules de silice, d'alumine, de titane ou d'oxyde de zinc.

**2.** Substrat à motifs selon la revendication 1, dans lequel les groupes hydrophiles comprennent un groupe alkyle fonctionnalisé, où "fonctionnalisé" signifie que le groupe alkyle peut avoir un ou plusieurs groupes fonctionnels, qui sont de préférence choisis dans le groupe constitué d'amine (NH$_2$), d'hydroxyle (OH), de carboxyle (CO$_2$H) et d'hydroxyde de sulfonyle (SOsH);

ou, dans le cas où les groupes hydrophiles sont des groupes thioéther hydrophiles, dans lequel les groupes hydrophiles sont dérivés de l'acide aminé cystéine, de protéines hydrophiles contenant de la cystéine, de peptides hydrophiles contenant de la cystéine, de sucres contenant des thiols, de thiol-PEG, ou de polymère PVA contenant des thiols, et de polysaccharides contenant des thiols; ou dans lequel les groupes hydrophiles sont dérivés d'une biomolécule fonctionnalisée par des thiols, telle que la biotine-PEG-SH;

et dans lequel les groupes thioéthers hydrophobes comprennent un groupe alkyle ou un groupe polyfluoroalkyle, le groupe alkyle étant de préférence un groupe alkyle linéaire, ramifié ou cyclique C$_6$-C$_{30}$ et le groupe polyfluoroalkyle étant de préférence un groupe polyfluoroalkyle ramifié ou linéaire C$_1$ à C$_{14}$, de préférence un groupe polyfluoroalkyle linéaire C$_4$ à C$_{12}$.

3. Méthode de production d'un substrat à motifs comportant des zones hydrophiles entourées de zones hydrophobes, comprenant les étapes suivantes:

(a) fournir une composition (A) contenant des nanoparticules et un silane trialkoxy ou dialkoxyalkyle contenant une double liaison ou une triple liaison dans un solvant;
(b) fournir un substrat ayant une surface (B);
(c) appliquer la composition (A) sur la surface (B) du substrat;
(d) séchage du substrat contenant la composition (A);
(e) mise en contact de la surface (B) avec un thiol hydrophobe ou hydrophile ou un disulfure hydrophobe ou hydrophile;
(f) irradiation d'une partie de la surface (B) avec de la lumière UV;
(g) mise en contact de la surface (B) avec un thiol hydrophile ou hydrophobe ou un disulfure hydrophile ou hydrophobe; et
(h) irradiation de la surface (B) avec de la lumière UV;
dans laquelle, dans l'une des étapes (e) et (g), la surface (B) est mise en contact avec un thiol ou un disulfure hydrophobe et dans l'autre des étapes (e) et (g), la surface (B) est mise en contact avec un thiol ou un disulfure hydrophile;
dans lequel les nanoparticules sont des nanoparticules de silice, d'alumine, de titane ou d'oxyde de zinc.

4. Méthode de production d'un substrat à motifs comportant des zones hydrophiles entourées de zones hydrophobes, comprenant les étapes suivantes:

(a) fournir une composition (A) contenant des nanoparticules et un silane trialkoxy ou dialkoxyalkyle contenant une double liaison ou une triple liaison dans un solvant;
(b) fournir un substrat ayant une surface (B);
(c) appliquer la composition (A) sur la surface (B) du substrat;
(d) séchage du substrat contenant la composition (A);
(e) mise en contact de la surface (B) avec un thiol hydrophobe ou un disulfure hydrophobe;
(f) irradier la surface (B) avec de la lumière UV pour produire des nanoparticules portant des groupes thioéthers hydrophobes sur la surface (B); et
(g) oxydation d'une partie de la surface (B) avec de la lumière UV ou d'une lumière laser pour produire des zones hydrophiles sur la surface (B);

dans lequel les nanoparticules sont des nanoparticules de silice, d'alumine, de titane ou d'oxyde de zinc.

5. Méthode de production d'un substrat à motifs comportant des zones hydrophiles entourées de zones hydrophobes, comprenant les étapes suivantes:

(a) fournir une composition (A) contenant des nanoparticules et un silane trialkoxy ou dialkoxyalkyle contenant une double liaison ou une triple liaison dans un solvant;
(b) fournir un substrat ayant une surface (B);
(c) appliquer la composition (A) sur la surface (B) du substrat;
(d) séchage du substrat contenant la composition (A);
(e) mise en contact d'une partie de la surface (B) avec un thiol hydrophobe ou hydrophile ou un disulfure hydrophobe ou hydrophile;
(f) irradiation de la surface (B) avec de la lumière UV;
(g) mise en contact de la surface (B) avec un thiol hydrophile ou hydrophobe ou un disulfure hydrophile ou hydrophobe; et
(h) irradiation de la surface (B) avec de la lumière UV;
dans laquelle, dans l'une des étapes (e) et (g), la surface (B) est mise en contact avec un thiol ou un disulfure hydrophobe et dans l'autre des étapes (e) et (g), la surface (B) est mise en contact avec un thiol ou un disulfure hydrophile;
dans lequel les nanoparticules sont des nanoparticules de silice, d'alumine, de titane ou d'oxyde de zinc.

**6.** Méthode de production d'un substrat à motifs comportant des zones hydrophiles entourées de zones hydrophobes, comprenant les étapes suivantes:

(a) fournir une composition (A) contenant des nanoparticules et un silane trialkoxy ou dialkoxyalkyle contenant une double liaison ou une triple liaison dans un solvant;
(b) fournir un substrat ayant une surface (B);
(c) appliquer la composition (A) sur la surface (B) du substrat;
(d) séchage du substrat contenant la composition (A);
(e) application d'un photo-initiateur sur la surface (B);
(f) irradier une partie de la surface (B) avec de la lumière UV ou d'une lumière laser;
(g) mise en contact de la surface (B) avec un thiol hydrophobe ou un disulfure hydrophobe;
(h) irradiation de la surface (B) avec de la lumière UV;

dans lequel les nanoparticules sont des nanoparticules de silice, d'alumine, de titane ou d'oxyde de zinc.

**7.** Méthode selon la revendication 3 ou 6, dans laquelle, à l'étape (f), la sélectivité du site est obtenue au moyen d'un masque photographique ou par l'utilisation d'un laser UV capable d'irradier sélectivement une partie seulement de la surface (B) avec de la lumière UV.

**8.** Méthode selon la revendication 3, 6 ou 7, dans laquelle, à l'étape (f), la sélectivité du site est obtenue au moyen d'un masque photographique et dans laquelle la méthode comprend en outre l'étape (e1) entre les étapes (e) et (f) et l'étape (f1) après l'étape (f):

(e1) recouvrir une partie de la surface (B) d'un masque photographique présentant un motif prédéterminé; et
(f1) retrait du masque photographique.

**9.** Méthode selon la revendication 5, dans laquelle la sélectivité de site est obtenue à l'étape (e), par impression par microcontact, marquage en porte-à-faux de microcanaux ou nanolithographie au stylo à immersion.

**10.** Méthode selon l'une quelconque des revendications 3 à 9, dans laquelle le trialkoxy ou dialkoxyalkyl silane contenant une double liaison ou une triple liaison est choisi parmi les trialkoxyvinylsilanes et les dialkoxyalkylvinylsilanes.

**11.** Méthode selon l'une quelconque des revendications 3 à 10, dans laquelle le solvant utilisé dans la composition (A) est un alcool, une cétone, un ester ou un hydrocarbure.

**12.** Méthode selon l'une des revendications 3 à 11, dans laquelle le substrat est en verre, en plastique, en ITO (oxyde d'indium et d'étain), en silicium, en quartz, en COC (copolymère d'oléfine cyclique), en PS (polystyrène), en PMMA (poly(méthacrylate de méthyle)), en papier, en cellulose ou en métal, et dans laquelle le substrat se présente sous la forme d'une lame, d'une plaquette, d'une plaque, d'un film ou d'un feuillet.

**13.** Méthode selon l'une des revendications 3 à 12, dans laquelle, à l'étape (c), la composition (A) est appliquée sur la surface (B) par revêtement par centrifugation, revêtement par immersion ou revêtement par pulvérisation.

**14.** Méthode selon l'une des revendications 3 à 13, dans lequel le thiol hydrophobe est représenté par la formule R-SH et le disulfure hydrophobe est représenté par la formule $R^1$-S-S-$R^2$, dans laquelle R, $R^1$ et $R^2$ sont indépendamment un groupe alkyle ou un groupe polyfluoroalkyle, dans laquelle le groupe alkyle est de préférence un groupe alkyle linéaire, ramifié ou cyclique $C_6$-$C_{30}$ et dans laquelle le groupe polyfluoroalkyle est de préférence un groupe polyfluoroalkyle ramifié ou linéaire $C_1$ à $C_{14}$, de préférence un groupe polyfluoroalkyle linéaire $C_4$ à $C_{12}$

**15.** Méthode selon l'une quelconque des revendications 3, 5 et 7 à 13, dans lequel le thiol hydrophile est représenté par la formule R'-SH et le disulfure hydrophile est représenté par la formule $R^3$-S-S-$R^4$, dans laquelle R', $R^3$ et $R^4$ sont indépendamment un groupe alkyle fonctionnalisé, dans laquelle "fonctionnalisé" signifie que le groupe alkyle peut avoir un ou plusieurs groupes fonctionnels, qui sont de préférence choisis dans le groupe constitué par l'amine ($NH_2$), l'hydroxyle (OH), le carboxyle ($CO_2H$) et l'hydroxyde de sulfonyle (SOs H) ; ou dans lequel le thiol hydrophile est choisi parmi l'acide aminé cystéine, les protéines hydrophiles contenant de la cystéine, les peptides hydrophiles contenant de la cystéine, les sucres contenant des thiols, le thiol-PEG, ou le polymère PVA contenant des thiols, et les polysaccharides contenant des thiols ou dans lequel le thiol hydrophile est une biomolécule fonctionnalisée par des thiols, telle que la biotine-PEG-SH.

**16.** Substrat à motifs selon la revendication 1, présentant des zones hydrophiles entourées de zones hydrophobes, produit selon le procédé de l'une quelconque des revendications 3 à 15.

Fig. 1

Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 3205394 A

- US 20110059264 A1

### Non-patent literature cited in the description

- **RYAN M. HENSARLING et al.** Clicking'' Polymer Brushes with Thiol-yne Chemistry: Indoors and Ou. *J. Am. Chem. Soc.,* 2009, vol. 131 (41), 14673-14675
- **PHILIPPE TINGAUT et al.** Highly efficient and straightforward functionalization of cellulose films with thiol-ene click chemistry. *J. Mater. Chem.,* 2011, vol. 21 (40), 16066-16076

- **WENQIAN FENG et al.** Surface Patterning via Thiol-Yne Click Chemistry: An Extremely Fast and Versatile Approach to Superhydrophilic-Superhydrophobic Micropatterns. *Adv. Mater. Interfaces,* 2014, vol. 1 (7), 1400269
- **POPOVA et al.** Droplet-Array (DA) Sandwich Chip: A Versatile Platform for High-Throughput Cell Screening Based on Superhydrophobic-Superhydrophilic Micropatterning. *Adv. Mater.,* 2015, vol. 27, 5217-5222